# EUROPÄISCHE PATENTSCHRIFT

(11) **EP 3 358 921 B1**
(45) Veröffentlichungstag und Bekanntmachung des Hinweises auf die Patenterteilung: **20.01.2021**
(21) Anmeldenummer: 18163958.4
(22) Anmeldetag: 13.04.2017
(51) Int. Cl.: H05K 7/14, B60K 1/04

(54) **LEISTUNGSELEKTRONISCHE ANORDNUNG UND FAHRZEUG HIERMIT**
POWER ELECTRONICS ASSEMBLY AND VEHICLES WITH SAME
DISPOSITIF ÉLECTRONIQUE DE PUISSANCE ET VÉHICULE CORRESPONDANT

(30) Priorität: 18.04.2016 DE 102016107083
(43) Veröffentlichungstag der Anmeldung: 08.08.2018
(62) Teilanmeldung aus: 17166538.3
(73) Patentinhaber: SEMIKRON Elektronik GmbH & Co. KG, 90431 Nürnberg (DE)
(72) Erfinder: Frank, Thomas, 91207 Lauf (DE); Walter, Christian, 91522 Ansbach (DE); Weiß, Stefan, 91315 Höchstadt Aisch (DE); Ziegler, Thomas, 91287 Plech (DE)

(56) Entgegenhaltungen:
- EP-A1- 2 239 768
- EP-A1- 2 378 552
- EP-A2- 1 840 961
- US-A1- 2004 245 548
- US-A1- 2009 085 188

## Beschreibung

Die Erfindung beschreibt eine leistungselektronische Anordnung mit einem Leistungshalbleitermodul und mit einer Montageeinrichtung, sowie ein elektrisches Fahrzeug hiermit.

Aus dem Stand der Technik, beispielhaft offenbart in der DE 10 2010 053 135 A1, ist eine Montageeinheit für das elektrische Leistungsteil in einem batteriebetriebenen Flurförderzeug bekannt, mit einer an einem Haltebauteil des Flurförderzeugs anbringbaren Montageplatte, einer die Leistungselektronik tragenden Halbleiterplatte und einem die Halbleiterplatte abdeckenden Gehäusedeckel, wobei die Halbleiterplatte unmittelbar an der Montageplatte angebracht ist.

Die US 2009085188 A1 offenbart ein Leistungshalbleitermodul. Dieses weist auf: ein Leistungshalbleiterelement; ein Gehäuse zum Aufnehmen des Leistungshalbleiterelementes; einen Steueranschluss, welcher mit einer Steuerelektrode des Leistungshalbleiterelementes verbunden ist, wobei der Steueranschluss so angebracht ist, dass er von einer oberen Oberfläche des Gehäuses hervorragt; und eine leitende Feder, in welche der Steueranschluss so eingeführt ist, dass eine Innenfläche der Feder in Kontakt mit zumindest einem Teil der Seitenfläche des Steueranschlusses hat, wobei die leitende Feder elektrisch mit einem gedruckten Substrat verbunden ist, welches so platziert ist, dass es der oberen Oberfläche des Gehäuses gegenüberliegt, und somit ein Druckkontakt mit dem gedruckten Substrat hergestellt wird.

Die EP 2 378 552 A1 offenbart ein Leistungshalbleitermodul mit mindestens einem Substrat, schaltungsgerecht angeordnete Leiterbahnen, einem Gehäuse und mindestens einem ersten und einem zweiten Anschlusselement. Die Anschlusselemente weisen jeweils einen ersten Kontaktabschnitt, einen zweiten Kontaktabschnitt und einen federnden Abschnitt auf. Für eine kompakte Anordnung und zur Vermeidung einer elektromagnetischen Induktion ist erfindungsgemäß vorgesehen, dass der federnde Abschnitt des zweiten Anschlusselementes als Schraubenfeder ausgebildet ist und das erste Anschlusselement zumindest teilweise umschließt.

In Kenntnis des genannten Standes der Technik, liegt der Erfindung die Aufgabe zugrunde, ein Leistungshalbleitermodul im Rahmen einer leistungselektronischen Anordnung und einem Fahrzeug vorzustellen, wobei die Integration des Leistungshalbleitermoduls in das Fahrzeug besonders wirksam ausgestaltet ist.

Diese Aufgabe wird erfindungsgemäß gelöst durch eine leistungselektronische Anordnung mit den Merkmalen des Anspruchs 1, sowie durch ein Fahrzeug mit den Merkmalen des Anspruchs 9. Bevorzugte Ausführungsformen sind in den jeweiligen abhängigen Ansprüchen beschrieben.

Die erfindungsgemäße leistungselektronische Anordnung ist ausgebildet mit einem Leistungshalbleitermodul, mit einer Kontaktfeder, mit einem Lastverbindungselement und mit einer Montageeinrichtung, die bevorzugt als Teil eines elektrisch betriebenen Fahrzeugs ausgebildet ist, wobei das Leistungshalbleitermodul ein Lastanschlusselement aufweist, das bevorzugt aus dem Inneren des Leistungshalbleitermoduls nach außen ragt und bevorzugt dort eine erste externe Kontaktfläche, also eine Kontaktfläche zur externen Verbindung, aufweist und wobei das Lastverbindungselement eine zweite Kontaktfläche aufweist. Eine elektrisch leitende Druckkontaktverbindung, also ein kraftschlüssiger Kontakt, zwischen der ersten Kontaktfläche und der zweiten Kontaktfläche ist mittels der Kontaktfeder ausgebildet, wobei der hierfür notwendige Druck auf die Kontaktfeder dadurch ausgebildet wird, dass das Leistungshalbleitermodul mit der Montageeinrichtung kraftschlüssig, vorzugsweise mittels einer Schraubverbindung, verbunden ist und wobei das Lastanschlusselement durch eine metallische Grundplatte des Leistungshalbleitermoduls nach außen ragen, wobei das Lastanschlusselement gegenüber der Grundplatte elektrisch isoliert ist.

Einerseits kann es vorteilhaft sein, wenn die elektrisch leitende Druckkontaktverbindung als unmittelbare Verbindung zwischen der ersten Kontaktfläche und der zweiten Kontaktfläche ausgebildet ist.

Andererseits kann es vorteilhaft sein, wenn die elektrisch leitende Druckkontaktverbindung als mittelbare Verbindung zwischen der ersten Kontaktfläche und der zweiten Kontaktfläche ausgebildet ist, bevorzugt indem die Kontaktfeder zwischen der ersten und zweiten Kontaktfläche angeordnet ist, und elektrisch leitend ausgebildet ist, wobei eine dritte Kontaktfläche der Kontaktfeder mit der ersten Kontaktfläche sowie die vierte Kontaktfläche der Kontaktfeder mit der zweiten Kontaktfläche jeweils in unmittelbarem elektrischen Kontakt steht.

Besonders bevorzugt ist es, wenn die Montageeinrichtung einen Zapfen aufweist, der vorzugsweise aus einem elektrisch isolierenden Material besteht. Dabei kann der Zapfen ins Innere der als Schraubenfeder ausgebildeten Kontaktfeder hineinreichen. Ebenso kann der Zapfen durch eine Ausnehmung des Lastverbindungselements hindurch reichen. Weiterhin kann der Zapfen ins Innere des zumindest teilweise als Kontakthülse ausgebildeten Lastanschlusselements hineinreichen.

Die metallische Grundplatte des Leistungshalbleitermoduls kann einen Teil einer Kühleinrichtung ausbilden.

Das erfindungsgemäße elektrisch angetriebene Fahrzeug ist unter anderem ausgebildet mit einer leistungselektronischen Anordnung nach einem der vorhergehenden Ansprüche, mit einer Energiespeichereinrichtung und mit einem elektrischen Antriebsmotor als Haupt- oder Hilfsantrieb.

Besonders vorteilhaft ist es, wenn die Montageeinrichtung integraler Bestandteil einer Antriebsachse ist.

Ebenfalls vorteilhaft ist es, wenn die Energiespeichereinrichtung und der Antriebsmotor mittels einer Mehrzahl von Lastverbindungs- und zugeordneten Lastanschlusselementen mit dem Leistungshalbleitermodul der leistungselektronischen Anordnung elektrisch leitend verbunden sind.

Selbstverständlich können, sofern dies nicht per se ausgeschlossen ist, die im Singular genannten Merkmale, insbesondere die Lastanschluss- und Lastverbindungselemente, wie auch die Kontaktfedern und Zapfen, mehrfach in der jeweiligen Anordnung oder dem Fahrzeug vorhanden sein.

Es versteht sich, dass die verschiedenen Ausgestaltungen der Erfindung einzeln oder in beliebigen Kombinationen realisiert sein können, um Verbesserungen zu erreichen. Insbesondere sind die vorstehend und im Folgenden genannten und erläuterten Merkmale, unabhängig ob sie im Rahmen der Anordnung oder des Fahrzeugs genannt sind, nicht nur in den angegebenen Kombinationen, sondern auch in anderen Kombinationen oder in Alleinstellung einsetzbar, ohne den Rahmen der vorliegenden Erfindung zu verlassen.
Figur 1 zeigt schematisch eine Ausgestaltung einer erfindungsgemäßen leistungselektronischen Anordnung zur weiteren Erläuterung der Erfindung.
Figur 2 zeigt schematisch eine Ausgestaltung einer erfindungsgemäßen leistungselektronischen Anordnung.
Figuren 3 bis 5 zeigen schematisch verschiedene Varianten zu einer zweiten Ausgestaltung einer erfindungsgemäßen leistungselektronischen Anordnung.
Figur 6 zeigt eine weitere Variante der zweiten Ausgestaltung einer erfindungsgemäßen leistungselektronischen Anordnung in dreidimensionaler Ansicht.
Figur 7 zeigt schematisch ein erfindungsgemäßes elektrisches Fahrzeug.

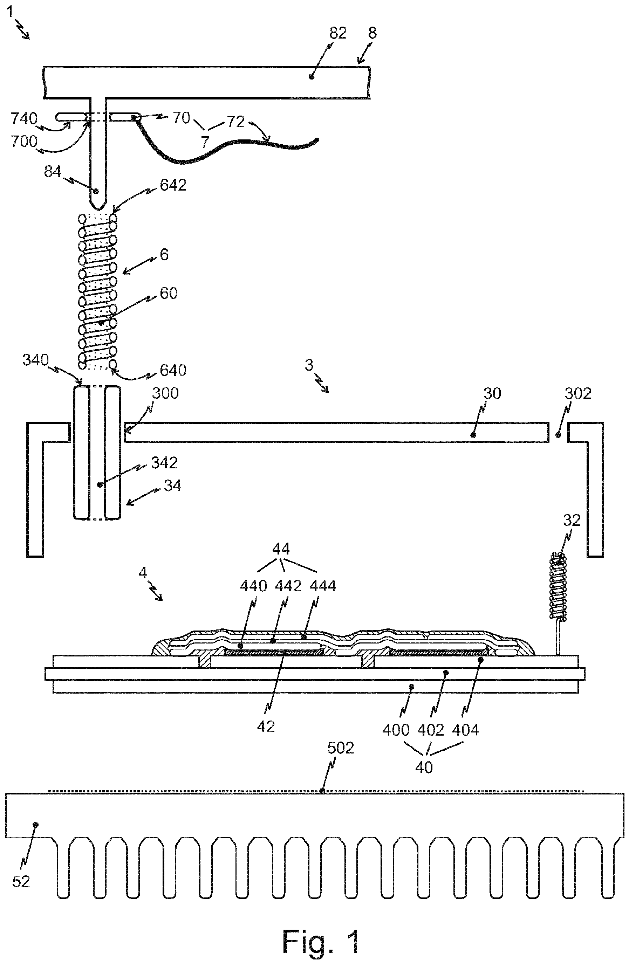

Figur 1 zeigt zur Erläuterung der Erfindung schematisch, in Explosionsdarstellung, eine Ausgestaltung einer leistungselektronischen Anordnung 1. Diese weist ein Leistungshalbleitermodul 3 auf, das seinerseits aus einem Gehäuse 30, einem Schaltungsträger 4 und einer metallischen Grundplatte, hier ausgebildet als eine Luftkühleinrichtung 52, besteht. Der Schaltungsträger 4 ist hierbei mittels einer wärmeleitenden Schicht 502 auf der Luftkühleinrichtung 52 angeordnet und wird von dem hier becherförmigen Gehäuse 30 zur Luftkühleinrichtung 52 hin überdeckt bzw. umschlossen.

Der Schaltungsträger 4 weist in dieser Ausgestaltung ein fachübliches Substrat 40 mit einem keramischen Isolierkörper 402 auf, der auf der der Luftkühleinrichtung 52 abgewandten Seite eine Mehrzahl von Leiterbahnen 404 aufweist, sowie auf der der Luftkühleinrichtung 52 zugewandten Seite eine metallische Kaschierung 400 trägt. Die Leiterbahnen 404 tragen Leistungshalbleiterbauelemente 42, die mittels einer internen Verbindungseinrichtung 44, die hier ebenfalls fachüblich mittels elektrisch leitender Folien 440, 444 und elektrisch isolierender Folien 442 ausgebildet ist, schaltungsgerecht verbunden sind.

Das Gehäuse 30 weist auf seiner der Luftkühleinrichtung 52 abgewandten Seite zwei Ausnehmungen 300, 302 auf. Die erste Ausnehmung 300 dient der Durchführung eines Lastanschlusselements 34, das somit aus dem Inneren des Leistungshalbleitermoduls 3 nach außen ragt, während die zweite Ausnehmung 302 der Durchführung eines Hilfsanschlusselements 32, das hier als Feder ausgebildet ist, dient.

Das Lastanschlusselement 34 ist hier als stromführende Hülse, genauer als ein Hohlzylinder, ausgebildet und kontaktiert im Inneren des Leistungshalbleitermoduls 3 eine Leiterbahn 404 des Substrats 40.

Weiterhin, nur als Ausschnitt, dargestellt ist eine Montageeinrichtung 8, wie sie beispielhaft Teil eines Flurförderzeugs sein kann. Diese Montageeinrichtung 8 weist einen Isolierstoffkörper 82 auf, der seinerseits, einstückig mit dem Isolierstoffkörper ausgebildet, einen Zapfen 84 aufweist. Dieser Zapfen 84 dient der Anordnung eines als Kontaktöse ausgebildeten Kontaktkörpers 70 eines Lastverbindungselements 7. Diese Kontaktöse weist eine durchgehende Ausnehmung 700 auf, mit der sie auf dem Zapfen 84 des Isolierstoffkörpers 82 der Montageeinrichtung 8 angeordnet ist. Von der Kontaktöse geht eine Anschlussleitung 72 weg, die beispielhaft der Verbindung zu einer Batterie, allgemeiner einer Energiespeichereinrichtung, oder zu einem elektrischen Antriebsmotor, allgemeiner einer elektrischen Maschine, dient. Diese Ausgestaltung des Lastverbindungselements 7 ist rein exemplarisch, grundsätzlich sind hier alle fachüblichen Varianten, beispielhaft auch in Gestalt von stromleitenden Schienen, möglich.

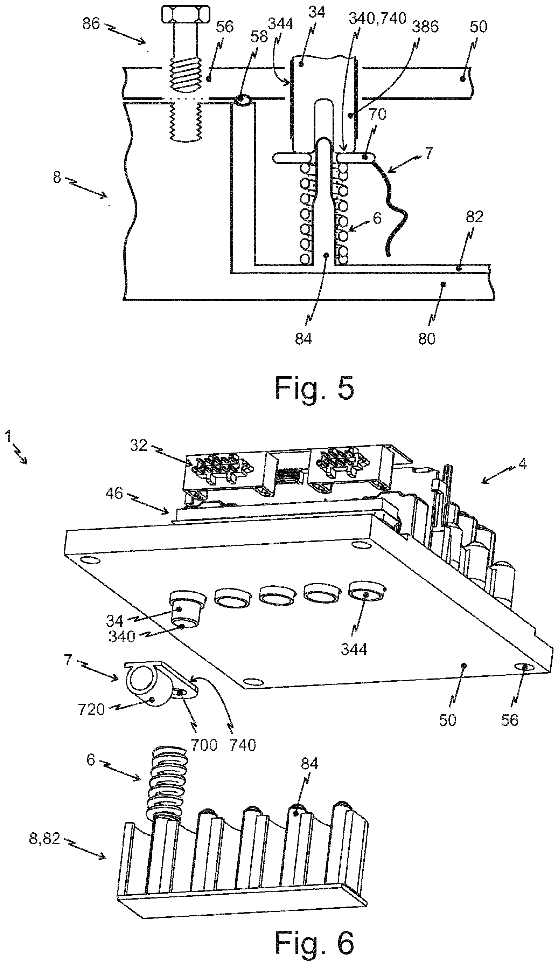

Weiterhin dargestellt ist eine als Schraubenfeder ausgebildete Kontaktfeder 6. Der Zapfen 84 reicht ins Innere 60 dieser Kontaktfeder 6 hinein und führt diese bei ihrer Anordnung zum Lastverbindungselement 7, genauer zu dessen Kontaktöse und auch zum Lastanschlusselement 34 des Leistungshalbleitermoduls 3. Die elektrisch leitende Verbindung zwischen dem Lastanschlusselement 34 und dem Lastverbindungselement 7 wird hergestellt, indem das Leistungshalbleitermodul 3 auf die Montageeinrichtung 8 geschraubt, also kraftschlüssig damit verbunden wird, vgl. auch Figur 5. Dabei wird Druck auf die Kontaktfeder 6 ausgeübt und diese gespannt. Somit ergibt sich einerseits ein elektrisch leitender Kontakt zwischen einer ersten Kontaktfläche 340 des Lastanschlusselements 34 und einer dritten Kontaktfläche 640 der Kontaktfeder 6, andererseits zwischen einer vierten Kontaktfläche 642 der Kontaktfeder 6 und einer zweiten Kontaktfläche 740 des Lastverbindungselements 7, hier genauer dessen Kontaktöse 70. Selbstverständlich ist die Kontaktfeder 6 aus leitfähigem Material, vorzugsweise Metall. Somit besteht hier eine mittelbare elektrisch leitende Druckkontaktverbindung der ersten und zweiten Kontaktfläche 340, 740.

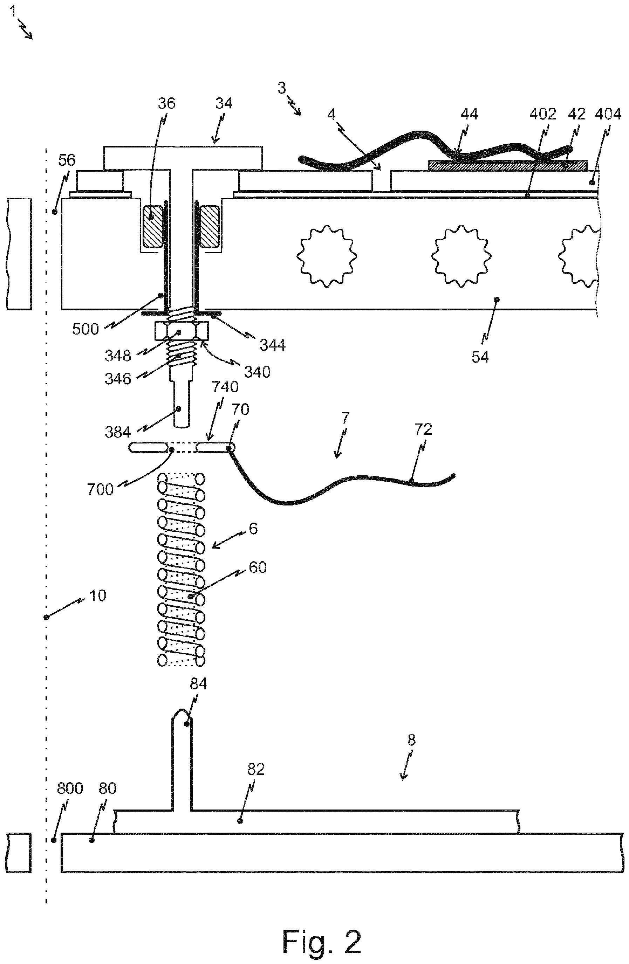

Figur 2 zeigt schematisch, in Explosionsdarstellung, eine erste Ausgestaltung einer erfindungsgemäßen leistungselektronischen Anordnung 1. Diese weist ein Leistungshalbleitermodul 3 auf, das seinerseits einen Schaltungsträger 4 und eine metallische Grundplatte, hier ausgebildet als eine Flüssigkeitskühleinrichtung 54, aufweist.

Der Schaltungsträger 4 weist in dieser Ausgestaltung ein fachübliches Isoliersubstrat auf, das auf der der Flüssigkeitskühleinrichtung abgewandten Seite eine Mehrzahl von Leiterbahnen 404 aufweist, die gegenüber der Flüssigkeitskühleinrichtung durch einen Isolierstoffkörper 402 elektrisch isoliert angeordnet sind. Die Leiterbahnen 404 tragen Leistungshalbleiterbauelemente 42, die mittels einer internen Verbindungseinrichtung 42, die hier fachüblich mittels Drahtbondverbindungen ausgebildet sind, schaltungsgerecht verbunden sind.

Die Flüssigkeitskühleinrichtung 54 weist eine Ausnehmung 500 auf, durch die ein Lastanschlusselement 34 hindurchreicht. In dieser Ausnehmung 56 ist zusätzlich ein Stromsensor 36 angeordnet. Das Lastanschlusselement 34 ist mittels einer Isolationseinrichtung 344 gegenüber der Flüssigkeitskühleinrichtung 54 elektrisch isoliert. Zudem weist das Lastanschlusselement 34 ein Schraubgewinde 346 und eine Schraubenmutter 348 auf, womit es zur Kühleinrichtung 54 fixiert angeordnet ist. Die Schraubenmutter 348 bildet hier die erste Kontaktfläche 340, diejenige des Lastanschlusselements 34 aus. In der Verlängerung des Schraubgewindes 346 weist das Lastanschlusselement 34 noch einen zapfenartigen Abschnitt 384 auf.

Weiterhin, wiederum nur als Ausschnitt, dargestellt ist eine Montageeinrichtung 8. Diese weist einen Isolierstoffkörper 82 auf, der seinerseits, einstückig mit dem Isolierstoffkörper ausgebildet, einen Zapfen 84 aufweist. Dieser Zapfen 84 fluchtet mit dem zapfenartigen Abschnitt 384 des Lastanschlusselements 34, ohne dieses in montiertem Zustand zu berühren, wobei dies nicht einschränkend zu verstehen ist. Dieser zapfenartige Abschnitt 384 dient der Anordnung eines als Kontaktöse ausgebildeten Kontaktkörpers 70 eines Lastverbindungselements 7. Diese Kontaktöse weist hierfür eine durchgehende Ausnehmung 700 auf. Von der Kontaktöse 70 geht wie oben zu Figur 1 bereits beschrieben eine Anschlussleitung 72 weg. Auch hier ist diese Ausgestaltung des Lastverbindungselements 7 rein exemplarisch, grundsätzlich sind hier alle fachüblichen Varianten möglich.

Auf dem Zapfen 84 der Montageeinrichtung 8 ist die Kontaktfeder 6 derart angeordnet, dass der Zapfen 84 teilweise ins Innere 60 der als Schraubenfeder ausgebildeten Kontaktfeder 6 hineinreicht. Der zapfenartig Abschnitt 384 des Lastanschlusselements 34 ragt nicht nur durch die Ausnehmung 700 der Kontaktöse 70 des Lastverbindungselements 7, sondern auch ins Innere 60 der Kontaktfeder 6 hinein. Hierdurch sind bereits während Montage der Anordnung die Kontaktfeder 6 und das Lastverbindungselement 7 zueinander ausgerichtet.

Im Unterschied zur ersten Ausgestaltung gemäß Figur 1, ist hier die Kontaktfeder 6 selbst nicht an der Stromführung beteiligt, da die zweite Kontaktfläche 740, diejenige des Lastverbindungselements 7 in direktem elektrisch leitenden Kontakt mit der ersten Kontaktfläche 340, derjenigen des Lastanschlusselements 34, steht, wodurch eine unmittelbare elektrisch leitende Druckkontaktverbindung ausgebildet wird.

Diese unmittelbare elektrisch leitende Druckkontaktverbindung zwischen dem Lastanschlusselement 34 und dem Lastverbindungselement 7 wird hergestellt, indem das Leistungshalbleitermodul 3 auf die Montageeinrichtung 8 geschraubt wird, wie dies durch die gestrichelte Linie 10 angedeutet ist. Dabei wird Druck auf die Kontaktfeder 6 ausgeübt und diese gespannt. Somit drückt die Kontaktfeder 6 auf die Kontaktöse 70 des Lastverbindungselements 7, wodurch dessen erste Kontaktfläche 340 auf die zweite Kontaktfläche 740 des Lastverbindungselements 7 gedrückt wird.

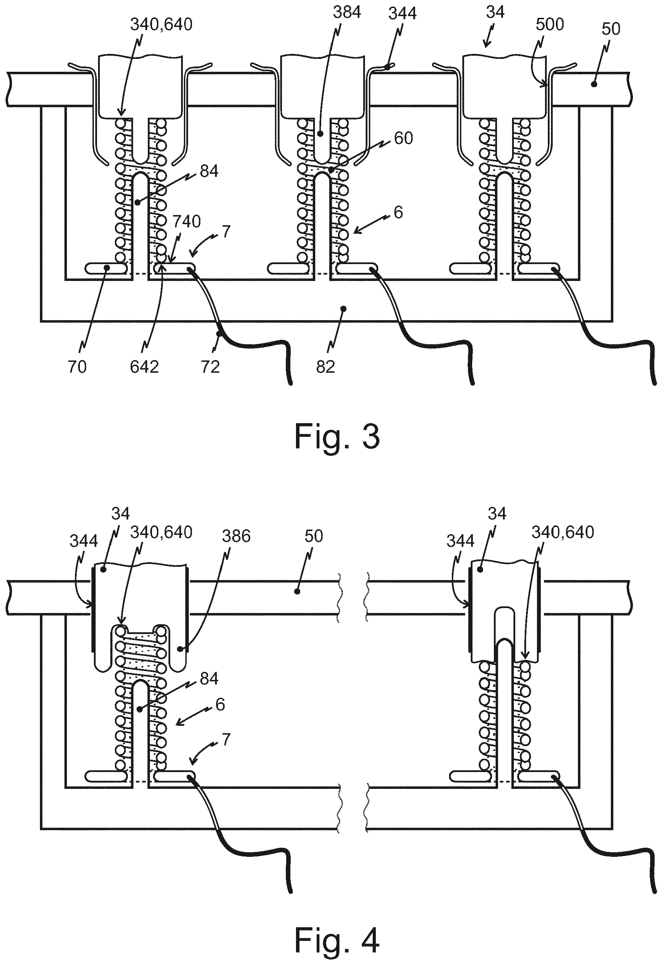

Figuren 3 bis 5 zeigen schematisch verschiedene Varianten zu einer zweiten Ausgestaltung einer erfindungsgemäßen leistungselektronischen Anordnung. Den Varianten gemäß Figur 3 und 4 ist gemeinsam, dass hier eine metallische Grundplatte 50 eines Leistungshalbleitermoduls dargestellt ist, wobei eine Mehrzahl von Lastanschlusselementen 34 durch Ausnehmungen 500 dieser Grundplatte 50 und von dieser mittels einer Isolationseinrichtung 344 elektrisch isoliert hindurchreichen. Weiterhin gemeinsam ist, dass ein Isolierstoffkörper 82 einer Montageeinrichtung 8 eine Mehrzahl von Zapfen 84 aufweist, wobei jedem Zapfen 84 ein Lastverbindungselement 7 zugeordnet ist. Die Kontakteinrichtung 70 jedes Lastverbindungselements 7 weist eine Ausnehmung 700 auf, durch die der zugeordnete Zapfen 84 hindurchreicht. Weiterhin ist auf jedem Zapfen 84 eine Kontaktfeder 6 angeordnet, wobei der Zapfen 84 ins Innere 60 der als Schraubenfeder ausgebildeten Kontaktfeder 6 hineinreicht.

Bei der Variante gemäß Figur 3 sind die Lastanschlusselemente 34 zylinderförmig mit jeweils einem zentral fluchtenden zapfenartigen Abschnitt 384 ausgebildet. Dieser zapfenartige Abschnitt 384 ist fluchtend mit dem jeweils zugeordneten Zapfen 84 der Montageeinrichtung 8 angeordnet, wobei der Zapfen 84 bzw. der zapfenartige Abschnitt 384 von entgegengesetzten Seiten ins Innere 60 der als Schraubenfeder ausgebildeten Kontaktfeder 6 hineinreichen und diese somit in ihrer Position fixieren.

Die elektrisch leitende Druckkontaktverbindung zwischen der ersten Kontaktfläche 340, derjenigen des Lastanschlusselements 34, und der zweiten Kontaktfläche 740, derjenigen des Lastverbindungselements 7, ist hier jeweils als mittelbare Verbindung zwischen der ersten Kontaktfläche 340 und der zweiten Kontaktfläche 740 ausgebildet ist, indem die Kontaktfeder 6 zwischen der ersten und zweiten Kontaktfläche angeordnet ist, und elektrisch leitend ausgebildet ist, und wobei eine dritte Kontaktfläche 640 der Kontaktfeder 6 mit der ersten Kontaktfläche 340 sowie die vierte Kontaktfläche 642 der Kontaktfeder 6 mit der zweiten Kontaktfläche 740 jeweils in unmittelbarem elektrischen Kontakt stehen. Selbstverständlich sind miteinander in unmittelbarem elektrischen Kontakt stehende Kontaktflächen hier, wie auch im Allgemeinen, einander immer zugewandt.

Bei der Variante gemäß Figur 4 sind, im Gegensatz zur Variante gemäß Figur 3, die Lastanschlusselemente 34 zylinderförmig mit jeweils einem zentral fluchtenden hülsenartigen Abschnitt 386 ausgebildet. Bei einer Ausgestaltung dieses hülsenartigen Abschnitts 386 ragt ein Abschnitt der Kontaktfeder 6 vollständig in diesen hülsenartigen Abschnitt hinein. Bei einer anderen Ausgestaltung ragt der Zapfen 84 in den hülsenartigen Abschnitt 386 hinein, während die Kontaktfeder 6 mit der Deckfläche, die eine umlaufende Vertiefung aufweisen kann und die die erste Kontaktfläche 340 ausbildet, in unmittelbarem elektrischen Kontakt steht.

Die Variante gemäß Figur 5 zeigt ein Ausschnitt aus einer Montageeinrichtung 8 dargestellt wie sie insbesondere Teil eines Flurförderzeugs sein kann. Diese Montageeinrichtung 8 weist den bereits bekannten Isolierstoffkörper 82 mit einstückig daraus ausgebildetem Zapfen 84 und einen metallischen Grundkörper 80 auf.

Die metallische Grundplatte 50 eines Leistungshalbleitermoduls 3 weist eine Mehrzahl von Ausnehmungen 500, von denen nur eine dargestellt ist, auf durch die Lastanschlusselemente 34 hindurchreichen, die jeweils gegenüber der Grundplatte 50 mittels einer Isolationseinrichtung 344 elektrisch isoliert sind. Das jeweilige Lastanschlusselement 34 weist wiederum einen hohlzylinderförmigen Abschnitt 386 auf, in den der Zapfen 84 der Montageeinrichtung 8 hineinreicht. Auf diesem Zapfen 84 ist wiederum die Kontaktfeder und das Lastverbindungselement mittels seiner Ausnehmung des Kontaktkörpers 6 angeordnet. Die Kontaktfeder 6 ist hier aus einem elektrisch isolierenden Werkstoff ausgebildet, oder weist zumindest eine elektrisch isolierende Oberfläche auf.

In Vorbereitung der Montage des Leistungshalbleitermoduls 3 zu der Montageeinrichtung 8, ist die ungespannte Kontaktfeder 6, wie auch das jeweilige Lastverbindungselement 34 auf dem zugeordneten Zapfen 84 angeordnet. Der Zapfen 84 reicht hierbei durch eine Ausnehmung 700 des Kontaktkörpers 70 des Lastverbindungselements 7 wie auch durch das Innere 60 der als Schraubenfeder ausgebildeten Kontaktfeder 6 hindurch.

Die kraftschlüssige Verbindung des Leistungshalbleitermoduls 3, genauer dessen Grundplatte 50 mit der Montageeinrichtung 8, erfolgt mittels einer Schraubverbindung 86. Hierzu weist, ohne Beschränkung der Allgemeinheit, die Montageeinrichtung 8 ein Innengewinde und die Grundplatte dazu fluchtend eine Ausnehmung 56 zur Anordnung einer Schraube auf. Durch Aufsetzen des Leistungshalbleitermoduls 3 auf die Montageeinrichtung 8 und verschrauben der beiden, wird die Feder 6 gespannt und durch den Druck den sie auf das Lastverbindungselement 7 ausübt, wird die elektrisch leitende Druckkontaktverbindung als unmittelbare Verbindung zwischen der ersten Kontaktfläche 340, derjenigen des Lastanschlusselements 34, und der zweiten Kontaktfläche 740, derjenigen des dem Lastanschlusselements 34 zugeordneten Lastverbindungselements 7, ausgebildet.

Zudem ist hier eine einfach auszuführende, allerdings sehr wirkungsvolle Dichteinrichtung 58 dargestellt. Diese ist ausgebildet als eine um alle Ausnehmungen 500 der Grundplatte 50 zur Durchführung von Lastanschlusselementen 34 herum verlaufende Rundschnurdichtung, die somit die Grundplatte 50 zur Montageeinrichtung 8, hier ohne Beschränkung der Allgemeinheit zu dessen Isolierstoffkörper 82, hin abdichtet. Fachüblich wären hier insbesondere einzelne Dichtungen zwischen den Lastanschlusselementen und der Grundplatte.

Figur 6 zeigt eine weitere Variante der zweiten Ausgestaltung einer erfindungsgemäßen leistungselektronische Anordnung 1 in dreidimensionaler Explosionsansicht. Dargestellt ist ein Leistungshalbleitermodul 3 mit metallischer Grundplatte 50. Auf dieser sind fachübliche Komponenten angeordnet. Dargestellt sind weiterhin Steckverbinder 32 für Hilfsanschlüsse und ein Joch 46 zur Kraftabstützung von nach Innen in das Leistungshalbleitermodul 3 gerichteten und von den Kontaktfedern 6 erzeugten Druckkräften auf die Lastanschlusselemente 34.

Die Lastanschlusselemente 34, von denen nur eines dargestellt ist, ragen in Isolierstoffhülsen 344 durch die Grundplatte 50 hindurch. Ausgebildet sind die Lastanschlusselemente 34 wiederum als Hohlzylinder mit einer ersten Kontaktfläche 340 an der Deckeloberfläche des Hohlzylinders.

Die Ausgestaltung der Montageeinrichtung 8, Lastverbindungseinrichtung 7 und der Kontaktfeder 6, wie auch deren Anordnung, erfolgt im Grunde wie zu Figur 5 beschrieben.

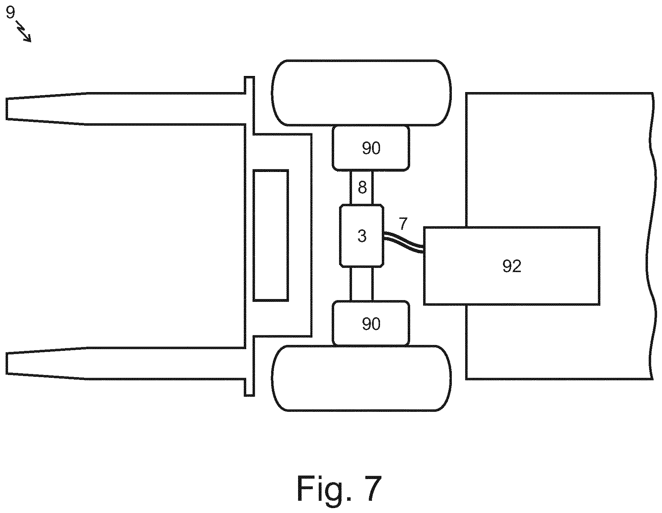

Figur 7 zeigt schematisch ein erfindungsgemäßes elektrisch angetriebenes Fahrzeug 9, hier konkret ein Flurförderzeug, wie beispielhaft einen Gabelstapler, in Teilansicht. Dargestellt ist insbesondere die Vorderachse des Gabelstaplers, mit je einem Fahrmotor 90 pro Rad. Die Vorderachse, allgemeiner Radträger oder Randaufhängung, fungiert hin dieser Ausgestaltung als die oben ausführliche beschriebene Montageeinrichtung 8, auf der direkt das Leistungshalbleitermodul 3 angeordnet ist. Dieses Leistungshalbleitermodul 3 ist mittels Lastverbindungselementen 7 mit den Fahrmotoren 90 und mit einer Energiespeichereinrichtung 92, also mit einer Batterie, genauer einem wieder aufladbaren Akkumulator, verbunden.

## Patentansprüche

1. Leistungselektronische Anordnung (1) mit einem Leistungshalbleitermodul (3), mit einer Kontaktfeder (6), mit einem Lastverbindungselement (7) und mit einer Montageeinrichtung (8), wobei
das Leistungshalbleitermodul (3) ein Lastanschlusselement (34) aufweist und eine erste externe Kontaktfläche (340) aufweist, wobei das Lastverbindungselement (7) eine zweite Kontaktfläche (740) aufweist und wobei eine elektrisch leitende Druckkontaktverbindung zwischen der ersten Kontaktfläche (340) und der zweiten Kontaktfläche (740) mittels der Kontaktfeder (6) ausgebildet ist und der hierfür notwendige Druck auf die Kontaktfeder (6) dadurch ausgebildet wird, dass das Leistungshalbleitermodul (3) mit der Montageeinrichtung (8) kraftschlüssig verbunden ist und wobei das Lastanschlusselement (34) durch eine metallische Grundplatte (50) des Leistungshalbleitermoduls (3) nach außen ragt und gegenüber der Grundplatte elektrisch isoliert ist.

2. Leistungselektronische Anordnung nach Anspruch 1,
wobei die elektrisch leitende Druckkontaktverbindung als unmittelbare Verbindung zwischen der ersten Kontaktfläche (340) und der zweiten Kontaktfläche (740) ausgebildet ist.

3. Leistungselektronische Anordnung nach Anspruch 1,
wobei die elektrisch leitende Druckkontaktverbindung als mittelbare Verbindung zwischen der ersten Kontaktfläche (340) und der zweiten Kontaktfläche (740) ausgebildet ist, bevorzugt indem die Kontaktfeder (6) zwischen der ersten und zweiten Kontaktfläche angeordnet ist, und elektrisch leitend ausgebildet ist, wobei eine dritte Kontaktfläche (640) der Kontaktfeder (6) mit der ersten Kontaktfläche (340) sowie die vierte Kontaktfläche (642) der Kontaktfeder (6) mit der zweiten Kontaktfläche (740) jeweils in unmittelbarem elektrischen Kontakt steht.

4. Leistungselektronische Anordnung nach einem der vorhergehenden Ansprüche, wobei die Kontaktfeder (6) als Schraubenfeder ausgebildet ist.

5. Leistungselektronische Anordnung nach Anspruch 4,
wobei die Montageeinrichtung (8) einen Zapfen (84) aufweist, der vorzugsweise aus einem elektrisch isolierenden Material besteht.

6. Leistungselektronische Anordnung nach Anspruch 5,
wobei der Zapfen (84) ins Innere (60) der als Schraubenfeder ausgebildeten Kontaktfeder (6) hineinreicht.

7. Leistungselektronische Anordnung nach Anspruch 4 oder 5,
der Zapfen (84) durch eine Ausnehmung (700) des Lastverbindungselements (7) hindurch reicht.

8. Leistungselektronische Anordnung nach einem der Ansprüche 4 bis 6,
wobei der Zapfen (84) ins Innere des zumindest teilweise als Kontakthülse ausgebildeten Lastanschlusselements (34) hineinreicht.

9. Leistungselektronische Anordnung nach einem der Ansprüche 1 bis 8,
die metallische Grundplatte (50), ausgebildet ist als Teil einer Kühleinrichtung (52, 54) des Leistungshalbleitermoduls (3).

10. Leistungselektronische Anordnung nach einem der vorhergehenden Ansprüche, wobei die Montageeinrichtung (8) und das Leistungshalbleitermodul (3) miteinander verschraubt sind.

11. Elektrisch angetriebenes Fahrzeug (9) mit einer leistungselektronischen Anordnung (1) nach einem der vorhergehenden Ansprüche, mit einer Energiespeichereinrichtung (92) und mit einem elektrischen Antriebsmotor (90) als Haupt- oder Hilfsantrieb.

12. Fahrzeug nach Anspruch 11,
wobei die Montageeinrichtung (8) integraler Bestandteil einer Antriebsachse ist.

13. Fahrzeug nach Anspruch 11 oder 12,
wobei die Energiespeichereinrichtung (92) und der Antriebsmotor (90) mittels einer Mehrzahl von Lastverbindungs- (7) und zugeordneten Lastanschlusselementen mit dem Leistungshalbleitermodul (3) der leistungselektronischen Anordnung (1) elektrisch leitend verbunden sind.

14. Fahrzeug nach einem der Ansprüche 11 bis 13,
wobei das Fahrzeug (9) als Flurförderzeug ausgebildet ist.

## Claims

1. Power electronics assembly (1) having a power semiconductor module (3), having a contact spring (6), having a load-connecting element (7) and having a mounting device (8), wherein
the power semiconductor module (3) has a load terminal element (34) and a first external contact face (340), wherein the load connecting element (7) has a second contact face (740), and wherein an electrically conductive pressure contact connection is formed between the first contact face (340) and the second contact face (740) by means of the contact spring (6), and the pressure necessary for this on the contact spring (6) is formed by virtue of the fact that the power semiconductor module (3) is connected in a frictionally locking fashion to the mounting device (8), and wherein the load terminal element (34) projects outwards through a metallic baseplate (50) of the power semiconductor module (3) and is electrically insulated from the baseplate.

2. Power electronics assembly according to Claim 1, wherein the electrically conductive pressure contact connection is embodied as a direct connection between the first contact face (340) and the second contact face (740).

3. Power electronics assembly according to Claim 1, wherein the electrically conductive pressure contact connection is embodied as a direct connection between the first contact face (340) and the second contact face (740), preferably in that the contact spring (6) is arranged between the first and second contact faces and is embodied in an electrically conductive fashion, wherein a third contact face (640) of the contact spring (6) is respectively in direct electrical contact with the first contact face (340), and the fourth contact face (642) of the contact spring (6) is respectively in direct electrical contact with the second contact face (740).

4. Power electronics assembly according to one of the preceding claims, wherein the contact spring (6) is embodied as a helical spring.

5. Power electronics assembly according to Claim 4, wherein the mounting device (8) has a pin (84) which is preferably composed of an electrically insulating material.

6. Power electronics assembly according to Claim 5, wherein the pin (84) extends into the interior (60) of the contact spring (6) which is embodied as a helical spring.

7. Power electronics assembly according to Claim 4 or 5, wherein the pin (84) extends through a cutout (700) in the load connecting element (7).

8. Power electronics assembly according to one of Claims 4 to 6, wherein the pin (84) extends into the interior of the load terminal element (34) which is embodied at least partially as a contact sleeve.

9. Power electronics assembly according to one of Claims 1 to 8, wherein the metallic baseplate (50) is embodied as part of a cooling device (52, 54) of the power semiconductor module (3).

10. Power electronics assembly according to one of the preceding claims, wherein the mounting device (8) and the power semiconductor module (3) are screwed to one another.

11. Electrically driven vehicle (9) having a power electronics assembly (1) according to one of the preceding claims, having an energy storage device (92) and having an electric drive motor (90) as a main drive or auxiliary drive.

12. Vehicle according to Claim 11, wherein the mounting device (8) is an integral component of a drive axle.

13. Vehicle according to Claim 11 or 12, wherein the energy storage device (92) and the drive motor (90) are electrically conductively connected to the power semiconductor module (3) of the power electronics assembly (1) by means of a multiplicity of load connecting elements (7) and assigned load terminal elements.

14. Vehicle according to one of Claims 11 to 13, wherein the vehicle (9) is embodied as an industrial truck.

## Revendications

1. Dispositif électronique de puissance (1) comprenant un module à semi-conducteur de puissance (3), un ressort de contact (6), un élément de connexion de charge (7) et un dispositif de montage (8), dans lequel le module à semi-conducteur de puissance (3) comporte un élément de connexion de charge (34) et présente une première surface de contact externe (340), dans lequel l'élément de connexion de charge (7) présente une deuxième surface de contact (740) et dans lequel une connexion de contact par pression électriquement conductrice entre la première surface de contact (340) et la deuxième surface de contact (740) est réalisée au moyen du ressort de contact (6), et la pression nécessaire à cet effet sur le ressort de contact (6) est créée par le fait que le module à semi-conducteur de puissance (3) est relié par complémentarité de force au dispositif de montage (8) et dans lequel l'élément de connexion de charge (34) fait saillie vers l'extérieur à travers une plaque de base métallique (50) du module à semi-conducteur de puissance (3) et est isolé électriquement de la plaque de base.

2. Dispositif électronique de puissance selon la revendication 1, dans lequel la connexion de contact par pression électriquement conductrice est réalisée sous la forme d'une connexion directe entre la première surface de contact (340) et la deuxième surface de contact (740).

3. Dispositif électronique de puissance selon la revendication 1,
dans lequel la connexion de contact par pression électriquement conductrice est réalisée sous la forme d'une connexion indirecte entre la première surface de contact (340) et la deuxième surface de contact (740), en faisant de préférence en sorte que le ressort de contact (6) soit disposé entre les première et deuxième surfaces de contact, et soit réalisé de manière électriquement conductrice,
dans lequel une troisième surface de contact (640) du ressort de contact (6) est en contact électrique direct avec la première surface de contact (340) et la quatrième surface de contact (642) du ressort de contact (6) est en contact électrique direct avec la deuxième surface de contact (740).

4. Dispositif électronique de puissance selon l'une des revendications précédentes,
dans lequel le ressort de contact (6) est réalisé sous la forme d'un ressort hélicoïdal.

5. Dispositif électronique de puissance selon la revendication 4,
dans lequel le dispositif de montage (8) comporte une broche (84) qui est de préférence constituée d'un matériau électriquement isolant.

6. Dispositif électronique de puissance selon la revendication 5,
dans lequel la broche (84) pénètre à l'intérieur (60) du ressort de contact (6) réalisé sous la forme d'un ressort hélicoïdal.

7. Dispositif électronique de puissance selon la revendication 4 ou 5,
dans lequel la broche (84) passe à travers un évidement (700) de l'élément de connexion de charge (7).

8. Dispositif électronique de puissance selon l'une des revendications 4 à 6,
dans lequel la broche (84) pénètre à l'intérieur de l'élément de connexion de charge (34), qui est au moins partiellement réalisé sous la forme d'une douille de contact.

9. Dispositif électronique de puissance selon l'une des revendications 1 à 8,
dans lequel la plaque de base métallique (50) est réalisée sous la forme d'une partie d'un dispositif de refroidissement (52, 54) du module à semi-conducteur de puissance (3).

10. Dispositif électronique de puissance selon l'une des revendications précédentes,
dans lequel le dispositif de montage (8) et le module à semi-conducteur de puissance (3) sont vissés l'un à l'autre.

11. Véhicule entraîné électriquement (9) comprenant un dispositif électronique de puissance (1) selon l'une des revendications précédentes, un dispositif accumulateur d'énergie (92) et un moteur d'entraînement électrique (90) en tant qu'entraînement principal ou auxiliaire.

12. Véhicule selon la revendication 11,
dans lequel le dispositif de montage (8) fait partie intégrante d'un essieu de transmission.

13. Véhicule selon la revendication 11 ou 12,
dans lequel le dispositif accumulateur d'énergie (92) et le moteur d'entraînement (90) sont reliés de manière électriquement conductrice au module à semi-conducteur de puissance (3) du dispositif électronique de puissance (1) au moyen d'une pluralité d'éléments de connexion de charge (7) et d'éléments de raccordement de charge associés.

14. Véhicule selon l'une des revendications 11 à 13, dans lequel le véhicule (9) est réalisé sous la forme d'un chariot de manutention.
